# EUROPEAN PATENT SPECIFICATION

(11) **EP 4 414 674 B1**
(45) Date of publication and mention of the grant of the patent: **24.12.2025**
(21) Application number: 23155989.9
(22) Date of filing: 10.02.2023
(51) Int. Cl.: G01K 1/02, G01J 5/00, G01K 3/00, G01K 3/10, G06N 20/00, H02B 13/00, G01K 3/14, H02B 13/065

(54) **SYSTEM, METHOD, AND COMPUTER PROGRAM ELEMENT FOR MONITORING A SWITCHGEAR**
SYSTEM, VERFAHREN UND COMPUTERPROGRAMMELEMENT ZUR ÜBERWACHUNG EINER SCHALTANLAGE
SYSTÈME, PROCÉDÉ ET ÉLÉMENT DE PROGRAMME INFORMATIQUE DE SURVEILLANCE D'UN APPAREILLAGE DE COMMUTATION

(43) Date of publication of application: 14.08.2024
(73) Proprietor: ABB SCHWEIZ AG, 5400 Baden (CH)
(72) Inventor: GITZEL, Ralf, 68165 Mannheim (DE); BOYACI, Aydin, 76137 Karlsruhe (DE); OSTROWSKI, Joerg, 8048 Zürich (CH)
(74) Representative: Maiwald GmbH

(56) References cited:
- CN-B- 102 829 885
- IDERUS SAMAT ET AL: "Temperature Rise Test on Medium Voltage Switchgear Assembly Based on IEC Standard", 2020 8TH INTERNATIONAL CONFERENCE ON ORANGE TECHNOLOGY (ICOT), IEEE, 18 December 2020 (2020-12-18), pages 1 - 5, XP033937777, DOI: 10.1109/ICOT51877.2020.9468746
- XIA HAOTIAN ET AL: "Temperature rise test and analysis of high current switchgear in distribution system", THE JOURNAL OF ENGINEERING, THE INSTITUTION OF ENGINEERING AND TECHNOLOGY, MICHAEL FARADAY HOUSE, SIX HILLS WAY, STEVENAGE, HERTS. SG1 2AY, UK, vol. 2019, no. 16, 1 March 2019 (2019-03-01), pages 754 - 757, XP006084814, DOI: 10.1049/JOE.2018.8371
- LI JIANGTAO ET AL: "A Novel Contact Temperature Calculation Algorithm in Distribution Switchgears for Condition Assessment", IEEE TRANSACTIONS ON COMPONENTS, PACKAGING AND MANUFACTURING TECHNOLOGY, IEEE, USA, vol. 9, no. 2, 1 February 2019 (2019-02-01), pages 279 - 287, XP011707635, ISSN: 2156-3950, [retrieved on 20190131], DOI: 10.1109/TCPMT.2018.2886404

## Description

### FIELD OF THE INVENTION

The present invention relates to a system for monitoring a switchgear, a method for monitoring a switchgear, and a computer program element.

### BACKGROUND OF THE INVENTION

Electrical equipment such as switchgear can suffer from small faults that change the electrical resistance of the system. These faults manifest as hot spots and can ultimately lead to catastrophic failures. Here a switchgear can be a high voltage, medium voltage, or low voltage switchgear.

S. Iderus and G. Peter, "Temperature Rise Test on Medium Voltage Switchgear Assembly Based on IEC Standard", 2020 8th International Conference on Orange Technology, 18 December 2020, pages 1-5, uses thermocouples to measure the temperatures of each phase of a three phase switchgear.

Thus, temperature sensors can be used to determine the state of such equipment (condition monitoring). The most commonly available sensors are thermal point sensors that measure the temperature at a specific position. A network of multiple point sensors can give a good description of the equipment's state.

One solution is to monitor parts of the switchgear, such as the phases, with an infrared thermographic camera to detect the hot spots. This is because infrared (IR) images can be used to identify technical problems within electrical equipment (e.g. switchgear) that lead to the overheating of components and to identify the hot spots themselves.

Temperature condition monitoring data can be interpretated by defining a temperature threshold for each of the phases of the equipment. If the threshold is exceeded, an alarm is raised.

However, such techniques do not provide early warnings of problems as they develop. There is a need to address these issues.

### SUMMARY OF THE INVENTION

Therefore, it would be advantageous to have an improved system for monitoring a switchgear.

The object of the present invention is solved with the subject matter of the independent claims, wherein further embodiments are incorporated in the dependent claims. It is to be noted that the system is described with respect to a switchgear, but finds utility in other electrical system than can suffer from components that overheat.

The independent claims define the invention and its scope of protection. The dependent claims define embodiments of the invention.

The following aspects and examples of the summary provide examples of how technical subject matters can be combined.

In an aspect, there is provided a system for monitoring a switchgear, the system comprising:
- at least one temperature sensor;
- a processing unit; and
- an output unit.

The at least one temperature sensor is configured to acquire temperature data for each location of at least one location of a switchgear at n time points. The at least one temperature sensor is configured to provide the temperature data to the processing unit. The processing unit is configured to determine n-1 rates of change of temperature for one or more locations of the at least one location with respect to the n temperature data for the one or more locations at the n time points. The processing unit is configured to determine n-1 correlation data points, wherein each correlation data point is a correlation between each rate of change of temperature of the n-1 rates of change of temperature with an associated temperature. For a particular rate of change of temperature the associated temperature is a first temperature of two temperatures used to determine the particular rate of change of temperature or is a second temperature of the two temperatures used to determine the particular rate of change of temperature or is an average of the first temperature and second temperature of the two temperatures used to determine the particular rate of change of temperature. The processing unit is configured to determine a state of the switchgear. The determination of the state of the switchgear comprises utilization of the n-1 rates of change of temperature for the one or more locations and at least n-1 of the n temperature data for the one or more locations and a shape of the n-1 correlation data points. The output unit is configured to output the determined state of the switchgear when the determined state of the switchgear is determined not to be normal or not to be healthy.

Thus, temperature data for a specific location, for example that with a maximum temperature of for example a phase of a two-phase or three-phase system, is acquired along with rate of change temperature, or temperature gradient data, as a function of time for the location, and that data over a time period is analysed to determine if there is a fault or if the operation is healthy or normal. Here not to be healthy is equivalent to not to be normal.

The manner in which this data changes with time, with respect to 2D information of n-1 temperature data and n-1 temperature gradient data, is used to indicate if a problem is occurring at the location, for example a hot spot has developed or is in the process of developing, because this 2D data set provides a "fingerprint" that can be used to determine if the operation is normal or abnormal. The determination of normal or abnormal operation can be made using reference data in some manner, for example via a relatively simple comparison of the acquired 2D data set with reference 2D data or a more complex utilization of a trained machine learning algorithm, such as a neural network. The determination of normal or abnormal operation with respect to one part of the switch gear, for example one phase, can be made by comparing the 2D data set for this phase with equivalent data for the other phases of for example a three-phase system

To put this another way, as parts of a switchgear heat up, the temperatures and rates of temperatures of parts provide a temporally varying 2D set of data that should change in a way that can signify that there is no problem with the parts of the switchgear.

In an example, the determination of the state of the switchgear comprises utilization of the n temperature data for the one or more locations.

In other words, n temperature data points, can be used to determine n-1 temperature gradients or rates of change of temperature for example by considering consecutive pairs of temperature data points, and the n-1 temperature gradient points and the n-1 temperature points can be used to determine the state of the switchgear, however all of the temperature data points can be directly used.

In an example, the at least one temperature sensor is configured to acquire temperature data for the at least one location of the switchgear at m time points, wherein m is greater than n, and wherein the n time points are consecutive time points of the m time points.

In other words, the system can in effect be acquiring temperature data in real time at time steps, and temperature gradient or rate of change of temperatures are determined for each temperature data point as it is acquired, for example via a comparison with the previously acquired temperature point for that location. Then a time window of n data points of temperature data yields n-1 temperature gradient points, and these temperature gradient points can be analysed along with n-1 (or indeed all of the n temperature data points) to determine a state of the switchgear.

In an example, each of the n-1 rates of change of temperature are determined for consecutive temperature data of the n temperature data for the one or more locations.

According to the invention, the processing unit is configured to determine n-1 correlation data points. Each correlation data point is a correlation between each rate of change of temperature of the n-1 rates of change of temperature with an associated temperature. For a particular rate of change of temperature the associated temperature is a first temperature of two temperatures used to determine the particular rate of change of temperature or is a second temperature of the two temperatures used to determine the particular rate of change of temperature or is an average of the first temperature and second temperature of the two temperatures used to determine the particular rate of change of temperature. The determination of the state of the switchgear comprises utilization of the n-1 correlation data points.

To put this another way, as the switchgear heats up, temperature data, for example a maximum temperature within a compartment associated with a phase of a switchgear, and the associated temperature gradient data, over a time window should have a specific shape with respect to actual values of temperature (T) and temperature gradient (dT) when plotted against each other. The shape of this curve can then be used to determine if the switchgear is heating up normally or is heating up abnormally, and there could be a hot spot developing, through for example comparison with reference shape data or utilization of shape recognition capabilities in software, for example in machine learning algorithms.

According to the invention, the determination of the state of the switchgear comprises utilization of a shape of the n-1 correlation data points.

In an example, the at least one temperature sensor comprises one or more infrared cameras, and the temperature data for the at least one location at the n time points is determined from one or more infrared images acquired at each of the n time points.

In an example, the at least one temperature sensor comprises one or more point sensors located at the at least one location, and the temperature data for the at least one location at the n time points is acquired by the one or more point sensors at each of the n time points.

In an example, the one or more locations are determined as one or more locations with one or more maximum temperatures.

In an example, the switchgear comprises a plurality of compartments, and the one or more locations comprises a plurality of locations, and each location of the plurality of locations is located in a different compartment of the plurality of compartments.

In an example, the processing unit is configured to implement a machine learning algorithm, and the determination of the state of the switchgear comprises utilization of the machine learning algorithm. The machine learning algorithm was trained on the basis of rates of change of temperature data and associated temperature data.

In an example, the rates of change of temperature and associated temperature data used to train the machine leaning algorithm comprises data for the at least one location of the switchgear or an equivalent switchgear.

In a second aspect, there is provided a method for monitoring a switchgear, the method comprising:
- acquiring by at least one temperature sensor temperature data for each location of at least one location of a switchgear at n time points;
- providing by the at least one temperature sensor the temperature data to the processing unit;
- determining by the processing unit n-1 rates of change of temperature for one or more locations of the at least one location with respect to the n temperature data for the one or more locations at the n time points;
- determining by the processing unit n-1 correlation data points, wherein each correlation data point is a correlation between each rate of change of temperature of the n-1 rates of change of temperature with an associated temperature, wherein for a particular rate of change of temperature the associated temperature is a first temperature of two temperatures used to determine the particular rate of change of temperature or is a second temperature of the two temperatures used to determine the particular rate of change of temperature or is an average of the first temperature and second temperature of the two temperatures used to determine the particular rate of change of temperature;
- determining by the processing unit a state of the switchgear, wherein the determining the state of the switchgear comprises utilizing the n-1 rates of change of temperature for the one or more locations and at least n-1 of the n temperature data for the one or more locations and a shape of the n-1 correlation data points; and
- outputting by an output unit the determined state of the switchgear when the determined state of the switchgear is determined not to be normal or not to be healthy.

In an embodiment, there is provided a switchgear comprising a system according to the first aspect.

According to another aspect, there is provided a computer program element controlling one or more of the systems as previously described which, if the computer program element is executed by a processor, is adapted to perform the methods as previously described.

According to an example, there could be provided a computer readable medium having stored a computer element as previously described.

The computer program element can for example be a software program but can also be a FPGA, a PLD or any other appropriate digital means.

The above aspects and examples will become apparent from and be elucidated with reference to the embodiments described hereinafter.

### BRIEF DESCRIPTION OF THE DRAWINGS

Exemplary embodiments will be described in the following with reference to the following drawings:
Fig. 1 shows a schematic example of a system for monitoring a switchgear;
Fig. 2 shows a schematic example of a method for monitoring a switchgear; and
Fig. 3 shows a plot of temperature data on the x axis with associate rate of change of temperature (temperature gradient data) for both healthy and unhealthy situations.

### DETAILED DESCRIPTION OF EMBODIMENTS

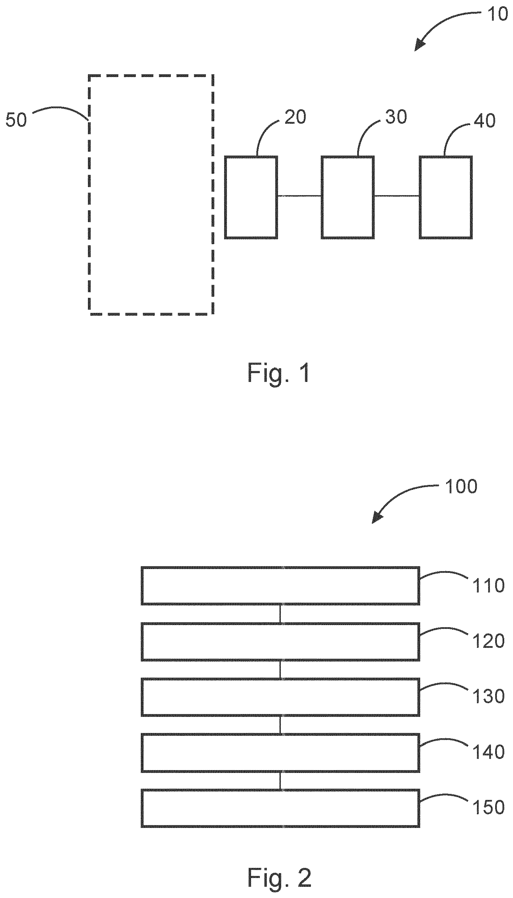

Fig. 1 shows an example of a system 10 for monitoring a switchgear. The system 10 comprises:
- at least one temperature sensor (20);
- a processing unit (30); and
- an output unit (40);

The at least one temperature sensor is configured to acquire temperature data for each location of at least one location of a switchgear 50 at n time points. n is an integer that for example can be 2, 5, 10, 20, 50, 100, 200, 500, 1000, 2000, 5000 or a number greater than 5000 and a number between any of the number here listed. The switchgear is shown as a dotted box in Fig. 1 because it is not part of the system as such, where for example the system could be retrofitted to a switchgear or a switchgear could in effect be manufactured with such a system. The at least one temperature sensor is configured to provide the temperature data to the processing unit. The processing unit is configured to determine n-1 rates of change of temperature for one or more locations of the at least one location with respect to the n temperature data for the one or more locations at the n time points. A rate of change in temperature is determined from adjacent temperature data points in time. The processing unit is configured to determine a state of the switchgear. The determination of the state of the switchgear comprises utilization of the n-1 rates of change of temperature for the one or more locations and at least n-1 of the n temperature data for the one or more locations. The output unit is configured to output the determined state of the switchgear when the determined state of the switchgear is determined not to be normal or not to be healthy.

Thus, temperature data for a specific location, for example that with a maximum temperature of for example a phase of a two-phase or three-phase system, is acquired along with rate of change temperature, or temperature gradient data, as a function of time for the location, and that data over a time period is analysed to determine if there is a fault or if the operation is healthy or normal.

The manner in which this data changes with time, with respect to 2D information of n-1 temperature data and n-1 temperature gradient data, is used to indicate if a problem is occurring at the location, for example a hot spot has developed or is in the process of developing, because this "D data set provides a "fingerprint" that can be used to determine if the operation is normal or abnormal. The determination of normal or abnormal operation can be made using reference data in some manner, for example via a relatively simple comparison of the acquired 2D data set with reference 2D data or a more complex utilization of a trained machine learning algorithm, such as a neural network. The determination of normal or abnormal operation with respect to one part of the switch gear, for example one phase, can be made by comparing the 2D data set for this phase with equivalent data for the other phases of for example a three-phase system

To put this another way, as parts of a switchgear heat up, the temperatures and rates of temperatures of parts provide a temporally varying 2D set of data that should change in a way that can signify that there is no problem with the parts of the switchgear.

In an example, the output unit is configured to output the determined state of the switchgear when the determined state of the switchgear is determined to be normal or to be healthy.

In an example, the determined state of the switchgear comprises an indication that overheating is occurring.

In an example, the determined state of the switchgear comprises an indication that overheating will occur.

In an example, the determined state of the switchgear comprises an indication of a location of the one or more locations.

According to the invention, the determination of the state of the switchgear comprises utilization of the n temperature data for the one or more locations.

In other words, n temperature data points are used to determine n-1 temperature gradients or rates of change of temperature for example by considering consecutive pairs of temperature data points, and the n-1 temperature gradient points and the n-1 temperature points are used to determine the state of the switchgear, however all of the temperature data points can be directly used.

According to an example, the at least one temperature sensor is configured to acquire temperature data for the at least one location of the switchgear 50 at m time points. m is greater than n, and the n time points are consecutive time points of the m time points.

In other words, the system can in effect be acquiring temperature data in real time at time steps, and temperature gradient or rate of change of temperatures are determined for each temperature data point as it is acquired, for example via a comparison with the previously acquired temperature point for that location. Then a time window of n data points of temperature data yields n-1 temperature gradient points, and these temperature gradient points can be analysed along with n-1 (or indeed all of the n temperature data points) to determine a state of the switchgear.

According to an example, each of the n-1 rates of change of temperature are determined for consecutive temperature data of the n temperature data for the one or more locations.

According to the invention, the processing unit is configured to determine n-1 correlation data points. Each correlation data point is a correlation between each rate of change of temperature of the n-1 rates of change of temperature with an associated temperature. For a particular rate of change of temperature the associated temperature is a first temperature of two temperatures used to determine the particular rate of change of temperature or is a second temperature of the two temperatures used to determine the particular rate of change of temperature or is an average of the first temperature and second temperature of the two temperatures used to determine the particular rate of change of temperature. The determination of the state of the switchgear comprises utilization of the n-1 correlation data points.

To put this another way, as the switchgear heats up, temperature data, for example a maximum temperature within a compartment associated with a phase of a switchgear, and the associated temperature gradient data, over a time window should have a specific shape with respect to actual values of temperature (T) and temperature gradient (dT) when plotted against each other. The shape of this curve can then be used to determine if the switchgear is heating up normally or is heating up abnormally, and there could be a hot spot developing, through for example comparison with reference shape data or utilization of shape recognition capabilities in software, for example in machine learning algorithms.

According to the invention, the determination of the state of the switchgear comprises utilization of a shape of the n-1 correlation data points.

According to an example, the at least one temperature sensor comprises one or more infrared cameras, and the temperature data for the at least one location at the n time points is determined from one or more infrared images acquired at each of the n time points.

According to an example, the at least one temperature sensor comprises one or more point sensors located at the at least one location, and the temperature data for the at least one location at the n time points is acquired by the one or more point sensors at each of the n time points.

According to an example, the one or more locations are determined as one or more locations with one or more maximum temperatures.

According to an example, the switchgear comprises a plurality of compartments, the one or more locations comprises a plurality of locations, and each location of plurality of locations is located in a different compartment of the plurality of compartments.

In an example, the processing unit is configured to access a database of rates of change of temperature data and associated temperature data, and wherein the determination of the state of the switchgear comprises utilization of the database of rates of change of temperature data and associated temperature data.

In an example, the determination of the state of the switchgear comprises a comparison of the n-1 rates of change of temperature for the one or more locations and the at least n-1 temperature data for the one or more locations with the database of rates of change of temperature data and associated temperature data.

In an example, the database of rates of change of temperature and associated temperature data comprises data for the at least one location of the switchgear or an equivalent switchgear.

In an example, the database of rates of change of temperature and associated temperature data comprises data at a plurality of time points.

According to an example, the processing unit is configured to implement a machine learning algorithm, and the determination of the state of the switchgear comprises utilization of the machine learning algorithm. The machine learning algorithm was trained on the basis of rates of change of temperature data and associated temperature data.

According to an example, the rates of change of temperature and associated temperature data used to train the machine leaning algorithm comprises data for the at least one location of the switchgear or an equivalent switchgear.

In an example, the rates of change of temperature and associated temperature data used to train the machine learning algorithm comprises data at a plurality of time points.

Fig. 2 shows a method 100 for monitoring a switchgear. The method comprises:
- acquiring 110 by at least one temperature sensor temperature data for each location of at least one location of a switchgear at n time points;
- providing 120 by the at least one temperature sensor the temperature data to the processing unit;
- determining 130 by the processing unit n-1 rates of change of temperature for one or more locations of the at least one location with respect to the n temperature data for the one or more locations at the n time points;
- determining 140 by the processing unit a state of the switchgear, wherein the determining the state of the switchgear comprises utilizing the n-1 rates of change of temperature for the one or more locations and at least n-1 of the n temperature data for the one or more locations; and
- outputting 150 by an output unit the determined state of the switchgear when the determined state of the switchgear is determined not to be normal or not to be healthy.

In an example, method comprises outputting by the output unit the determined state of the switchgear when the determined state of the switchgear is determined to be normal or to be healthy.

In an example, the determined state of the switchgear comprises an indication that overheating is occurring.

In an example, the determined state of the switchgear comprises an indication that overheating will occur.

In an example, the determined state of the switchgear comprises an indication of a location of the one or more locations.

According to the invention, the determining the state of the switchgear comprises utilizing the n temperature data for the one or more locations.

In an example, the method comprises acquiring by the at least one temperature sensor temperature data for the at least one location of the switchgear 50 at m time points, and where m is greater than n, and the n time points are consecutive time points of the m time points.

In an example, each of the n-1 rates of change of temperature are determined for consecutive temperature data of the n temperature data for the one or more locations.

According to the invention, the method comprises determining by the processing unit n-1 correlation data points. Each correlation data point is a correlation between each rate of change of temperature of the n-1 rates of change of temperature with an associated temperature (here correlation means associated with). For a particular rate of change of temperature the associated temperature is a first temperature of two temperatures used to determine the particular rate of change of temperature or is a second temperature of the two temperatures used to determine the particular rate of change of temperature or is an average of the first temperature and second temperature of the two temperatures used to determine the particular rate of change of temperature. The determining the state of the switchgear comprises utilization of the n-1 correlation data points.

According to the invention, the determining the state of the switchgear comprises utilizing a shape of the n-1 correlation data points.

In an example, the at least one temperature sensor comprises one or more infrared cameras, and the temperature data for the at least one location at the n time points is determined from one or more infrared images acquired at each of the n time points.

In an example, the at least one temperature sensor comprises one or more point sensors located at the at least one location, and the temperature data for the at least one location at the n time points is acquired by the one or more point sensors at each of the n time points.

In an example, the one or more locations are determined as one or more locations with one or more maximum temperatures.

In an example, the switchgear comprises a plurality of compartments, the one or more locations comprises a plurality of locations, and each location of plurality of locations is located in a different compartment of the plurality of compartments.

In an example, the method comprises accessing by the processing unit a database of rates of change of temperature data and associated temperature data, and the determining the state of the switchgear comprises utilizing the database of rates of change of temperature data and associated temperature data.

In an example, the determining the state of the switchgear comprises comparing the n-1 rates of change of temperature for the one or more locations and the at least n-1 temperature data for the one or more locations with the database of rates of change of temperature data and associated temperature data.

In an example, the database of rates of change of temperature and associated temperature data comprises data for the at least one location of the switchgear or an equivalent switchgear.

In an example, the database of rates of change of temperature and associated temperature data comprises data at a plurality of time points.

In an example, the method comprises implementing by the processing unit a machine learning algorithm, and the determining the state of the switchgear comprises utilizing the machine learning algorithm. The machine learning algorithm was trained on the basis of rates of change of temperature data and associated temperature data.

In an example, the rates of change of temperature and associated temperature data used to train the machine leaning algorithm comprises data for the at least one location of the switchgear or an equivalent switchgear.

In an example, the rates of change of temperature and associated temperature data used to train the machine learning algorithm comprises data at a plurality of time points.

A switchgear 50 can comprise a system 10 as described with respect to Fig. 1.

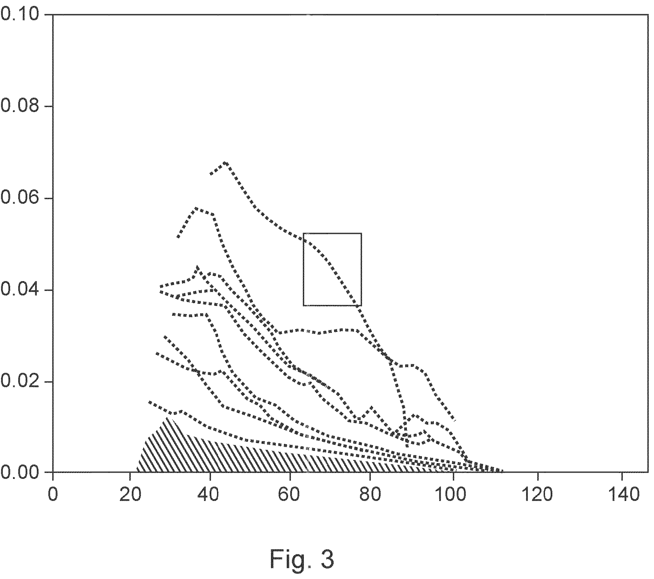

The system and method for monitoring a switchgear is described in further detail, with respect to specific embodiments, where reference is made to Fig. 3.

Fig. 3 shows a plot of rate of change of temperature against temperature for a number of locations in a compartment of a switchgear. Each point relates to a point in time, and in this case the temperature increases as time progresses. The top curves represent cases, where there is a fault in a phase of the switchgear and overheating is occurring. The bottom region, represented as a hashed region, has the same curves for the heating up where no fault is present. The box indicates that 5 data points are being analyzed at any one point in time, thus if all the data were considered to have already been acquired the bow would move gradually to the right, containing 5 data points at a time. These 5 data points in terms of their temperature and temperature gradients provide information on how a location of the switchgear is heating up, and whether that heating up in normal or abnormal. In Fig. 3 the fault is such that the top curves are significantly above the "healthy" curves, which has been done for ease of visibility, but less significant faults can be detected, where the curve is within or close to a region of normality, but its shape (of the 5 points) is such that it can be determined that there is a problem. Here, 5 data points is used as an example, and there can be fewer than this or many more that are analyzed.

One approach is to acquire temperature and temperature gradient data to provide in effect a time varying two dimensional look up table. This can be compared with reference two dimensional look up tables, enabling it to be determined if overheating is occurring, such as a loose joint or a higher than expected resistance within a busbar for example. Interpolation algorithms can be utilized mitigating the need to generate an excessive number of reference look up tables.

Another approach is to train a machine learning algorithm, such as a neural network on the basis of temperature and temperature gradient data for situations where a switchgear equivalent to the one operating is working correctly. Real data can then be analyzed to determine if overheating is occurring. The machine learning algorithm can also be trained with data relating to faults, through loosening joints at different locations, and for example replacing current carrying elements, for example a busbar, with a component with an intentionally higher than normal resistance at a position along its length.

In a specific embodiment, for monitoring 4 compartments of a switchgear an infrared camera can be located to view internally within each compartment or a number of point temperature sensors can be located within each compartment. The system then takes the highest temperature from each compartment (4 values in this example at each time point) and additionally computes the gradient over time for each of those (another 4 values in effect at each time point). These values are used as input for a machine learning algorithm.

Thus, in a specific embodiment at each time point there are n temperatures, n temperature gradients, that are used to describe a situation. The situation can be labeled as either healthy or faulty, and a label can be used that indicates future overheating will occur.

Switchgear can have a number of compartments, as discussed this can be 4, or more or less than four, and we can generalize this number to be y. Then, for the example of using a machine learning algorithm, an array of 2*n*y points (the 2 is temperature data and temperature gradient data) and n is the length of the time series of data used for analysis (for example 5 as shown in Fig. 3). Thus, for each of the compartments 2 values - e.g. maximum temperature and max temp gradient - are used. (it is to be noted that The time series number n could also be of variable length, e.g., when using LSTM neural networks.)

A basic Support Vector Machine or Neural Network can be used but a special case would be to use a 1 D-convolutional neural network to use the shape-recognition capability of the convolutional layers on the time series.

This input, for a real system is provided to a trained machine learning algorithm. The equivalent input, for example for a reference switchgear that can operate in healthy modes, and if necessary with faults, is used to provide equivalent data as input to train such a classification algorithm. There are different sets of labels one could apply coming from the following list: healthy, faulty, soon to overheat, current overload, phase imbalance. Healthy means that there is no fault. Faulty means that there is some fault. 'Soon to overheat' means that if nothing else changes, a temperature threshold will be exceeded soon. 'Current overload' means that the equipment is used beyond its ratings but there is no defect. 'Imbalance' means that not all phases carry the same current.

The system can be trained by providing situational data for each of the labels in enough quantity to describe the expected future input.

Furthermore, the system can be trained separately for heat-up and cool-down phases to address the different behavior in those modes of operation.

According to the invention, a computer program or computer program element is provided that is characterized by being configured to execute the method steps of the method according to one of the preceding embodiments, on an appropriate processor or system.

The computer program element might therefore be stored on a computer unit, which might also be part of an embodiment. This computing unit may be configured to perform or induce performing of the steps of the method described above. Moreover, it may be configured to operate the components of the above described system. The computing unit can be configured to operate automatically and/or to execute the orders of a user. A computer program may be loaded into a working memory of a data processor. The data processor may thus be equipped to carry out the method according to one of the preceding embodiments.

This exemplary embodiment of the invention covers both, a computer program that right from the beginning uses the invention and computer program that by means of an update turns an existing program into a program that uses the invention.

Further on, the computer program element might be able to provide all necessary steps to fulfill the procedure of an exemplary embodiment of the method as described above.

According to a further exemplary embodiment of the present invention, a computer readable medium, such as a CD-ROM, USB stick or the like, is presented wherein the computer readable medium has a computer program element stored on it which computer program element is described by the preceding section.

A computer program may be stored and/or distributed on a suitable medium, such as an optical storage medium or a solid state medium supplied together with or as part of other hardware, but may also be distributed in other forms, such as via the internet or other wired or wireless telecommunication systems.

However, the computer program may also be presented over a network like the World Wide Web and can be downloaded into the working memory of a data processor from such a network. According to a further exemplary embodiment of the present invention, a medium for making a computer program element available for downloading is provided, which computer program element is arranged to perform a method according to one of the previously described embodiments of the invention.

## Claims

1. A system (10) for monitoring a switchgear, the system comprising:
- at least one temperature sensor (20);
- a processing unit (30); and
- an output unit (40);
wherein the at least one temperature sensor is configured to acquire temperature data for each location of at least one location of a switchgear (50) at n time points;
wherein the at least one temperature sensor is configured to provide the temperature data to the processing unit;
wherein the processing unit is configured to determine n-1 rates of change of temperature for one or more locations of the at least one location with respect to the n temperature data for the one or more locations at the n time points;
wherein the processing unit is configured to determine n-1 correlation data points, wherein each correlation data point is a correlation between each rate of change of temperature of the n-1 rates of change of temperature with an associated temperature, wherein for a particular rate of change of temperature the associated temperature is a first temperature of two temperatures used to determine the particular rate of change of temperature or is a second temperature of the two temperatures used to determine the particular rate of change of temperature or is an average of the first temperature and second temperature of the two temperatures used to determine the particular rate of change of temperature;
wherein the processing unit is configured to determine a state of the switchgear, wherein the determination of the state of the switchgear comprises utilization of the n-1 rates of change of temperature for the one or more locations, at least n-1 of the n temperature data for the one or more locations and a shape of the n-1 correlation data points; and
wherein the output unit is configured to output the determined state of the switchgear when the determined state of the switchgear is determined not to be normal or not to be healthy.

2. System according to claim 1, wherein the determination of the state of the switchgear comprises utilization of the n temperature data for the one or more locations.

3. System according to any of claims 1-2, wherein the at least one temperature sensor is configured to acquire temperature data for the at least one location of the switchgear (50) at m time points, wherein m is greater than n, and wherein the n time points are consecutive time points of the m time points.

4. System according to any of claims 1-3, wherein each of the n-1 rates of change of temperature are determined for consecutive temperature data of the n temperature data for the one or more locations.

5. System according to any of claims 1-4, wherein the at least one temperature sensor comprises one or more infrared cameras, and wherein the temperature data for the at least one location at the n time points is determined from one or more infrared images acquired at each of the n time points.

6. System according to claim 1-4, wherein the at least one temperature sensor comprises one or more point sensors located at the at least one location, and wherein the temperature data for the at least one location at the n time points is acquired by the one or more point sensors at each of the n time points.

7. System according to any of claims 1-6, wherein the one or more locations are determined as one or more locations with one or more maximum temperatures.

8. System according to any of claims 1-7, wherein the switchgear comprises a plurality of compartments, wherein the one or more locations comprises a plurality of locations, and wherein each location of plurality of locations is located in a different compartment of the plurality of compartments.

9. System according to any of claims 1-8, wherein the processing unit is configured to implement a machine learning algorithm, and wherein the determination of the state of the switchgear comprises utilization of the machine learning algorithm, and wherein the machine learning algorithm was trained on the basis of rates of change of temperature data and associated temperature data.

10. System according to claim 9, wherein the rates of change of temperature and associated temperature data used to train the machine leaning algorithm comprises data for the at least one location of the switchgear or an equivalent switchgear.

11. A method (100) for monitoring a switchgear, the method comprising:
- acquiring (110) by at least one temperature sensor temperature data for each location of at least one location of a switchgear at n time points;
- providing (120) by the at least one temperature sensor the temperature data to a processing unit;
- determining (130) by the processing unit n-1 rates of change of temperature for one or more locations of the at least one location with respect to the n temperature data for the one or more locations at the n time points;
- determining by the processing unit n-1 correlation data points, wherein each correlation data point is a correlation between each rate of change of temperature of the n-1 rates of change of temperature with an associated temperature, wherein for a particular rate of change of temperature the associated temperature is a first temperature of two temperatures used to determine the particular rate of change of temperature or is a second temperature of the two temperatures used to determine the particular rate of change of temperature or is an average of the first temperature and second temperature of the two temperatures used to determine the particular rate of change of temperature;
- determining (140) by the processing unit a state of the switchgear, wherein the determining the state of the switchgear comprises utilizing the n-1 rates of change of temperature for the one or more locations, at least n-1 of the n temperature data for the one or more locations and a shape of the n-1 correlation data points; and
- outputting (150) by an output unit the determined state of the switchgear when the determined state of the switchgear is determined not to be normal or not to be healthy.

12. A switchgear (50) comprising a system (10) according to any of claims 1-10.

13. A computer program element for controlling a system according to any of claims 1-10 which when executed by a processor is configured to carry out the method of claim 11.

## Patentansprüche

1. System (10) zur Überwachung einer Schaltanlage, umfassend:
- mindestens einen Temperatursensor (20);
- eine Verarbeitungseinheit (30); und
- eine Ausgabeeinheit (40);
wobei der mindestens eine Temperatursensor dazu eingerichtet ist, Temperaturdaten für jeden Ort von mindestens einem Ort einer Schaltanlage (50) zu n Zeitpunkten zu erfassen;
wobei der mindestens eine Temperatursensor dazu eingerichtet ist, die Temperaturdaten an die Verarbeitungseinheit zu übermitteln;
wobei die Verarbeitungseinheit dazu eingerichtet ist, n-1 Änderungsraten der Temperatur für einen oder mehrere Orte des mindestens eines Ortes in Bezug auf die n Temperaturdaten für die einen oder mehreren Orte zu den n Zeitpunkten zu bestimmen;
wobei die Verarbeitungseinheit dazu eingerichtet ist, n-1 Korrelationsdatenpunkte zu bestimmen, wobei jeder Korrelationsdatenpunkt eine Korrelation zwischen jeder Änderungsrate der Temperatur der n-1 Änderungsraten der Temperatur mit einer zugeordneten Temperatur ist, wobei für eine bestimmte Änderungsrate der Temperatur die zugeordnete Temperatur eine erste Temperatur der zwei Temperaturen ist, die zur Bestimmung der bestimmten Änderungsrate der Temperatur verwendet werden, oder eine zweite Temperatur der zwei Temperaturen, oder ein Mittelwert der ersten und zweiten Temperatur der zwei Temperaturen, die zur Bestimmung der bestimmten Änderungsrate der Temperatur verwendet werden;
wobei die Verarbeitungseinheit dazu eingerichtet ist, einen Zustand der Schaltanlage zu bestimmen, wobei die Bestimmung des Zustands der Schaltanlage die Verwendung der n-1 Änderungsraten der Temperatur für die einen oder mehreren Orte, mindestens n-1 der n Temperaturdaten für die einen oder mehreren Orte und eine Form der n-1 Korrelationsdatenpunkte umfass; und
wobei die Ausgabeeinheit so eingerichtet ist, dass sie den ermittelten Zustand der Schaltanlage ausgibt, wenn der ermittelte Zustand der Schaltanlage als nicht normal oder nicht funktionsfähig ermittelt wird.

2. System nach Anspruch 1, wobei die Bestimmung des Zustands der Schaltanlage die Verwendung der n Temperaturdaten für die einen oder mehreren Orte umfasst.

3. System nach einem der Ansprüche 1-2, wobei der mindestens eine Temperatursensor dazu eingerichtet ist, Temperaturdaten für den mindestens einen Ort der Schaltanlage (50) zu m Zeitpunkten zu erfassen, wobei m größer als n ist, und wobei die n Zeitpunkte aufeinanderfolgende Zeitpunkte der m Zeitpunkte sind.

4. System nach einem der Ansprüche 1-3, wobei jede der n-1 Änderungsraten der Temperatur für aufeinanderfolgende Temperaturdaten der n Temperaturdaten für die einen oder mehreren Orte bestimmt wird.

5. System nach einem der Ansprüche 1-4, wobei der mindestens eine Temperatursensor ein oder mehrere Infrarotkameras umfasst und wobei die Temperaturdaten für den mindestens einen Ort zu den n Zeitpunkten aus einem oder mehreren Infrarotbildern bestimmt werden, die zu jedem der n Zeitpunkte aufgenommen werden.

6. System nach einem der Ansprüche 1-4, wobei der mindestens eine Temperatursensor einen oder mehrere Punktsensoren umfasst, die am mindestens einen Ort angeordnet sind, und wobei die Temperaturdaten für den mindestens einen Ort zu den n Zeitpunkten von den einen oder mehreren Punktsensoren zu jedem der n Zeitpunkte erfasst werden.

7. System nach einem der Ansprüche 1-6, wobei die einen oder mehreren Orte als ein oder mehrere Orte mit einer oder mehreren Maximaltemperaturen bestimmt werden.

8. System nach einem der Ansprüche 1-7, wobei die Schaltanlage eine Vielzahl von Fächern umfasst, wobei die einen oder mehreren Orte eine Vielzahl von Orten umfassen und wobei jeder Ort der Vielzahl von Orten in einem anderen Fach der Vielzahl von Fächern angeordnet ist.

9. System nach einem der Ansprüche 1-8, wobei die Verarbeitungseinheit dazu eingerichtet ist, einen Algorithmus für maschinelles Lernen zu implementieren, wobei die Bestimmung des Zustands der Schaltanlage die Verwendung des Algorithmus für maschinelles Lernen umfasst und wobei der Algorithmus für maschinelles Lernen auf Basis von Änderungsraten der Temperaturdaten und zugeordneten Temperaturdaten trainiert wurde.

10. System nach Anspruch 9, wobei die zur Schulung des Algorithmus für maschinelles Lernen verwendeten Änderungsraten der Temperatur und zugeordneten Temperaturdaten Daten für den mindestens einen Ort der Schaltanlage oder eine gleichwertige Schaltanlage umfassen.

11. Verfahren (100) zur Überwachung einer Schaltanlage, umfassend:
- Erfassen (110) von Temperaturdaten durch mindestens einen Temperatursensor für jeden Ort von mindestens einem Ort einer Schaltanlage zu n Zeitpunkten;
- Übermitteln (120) der Temperaturdaten durch den mindestens einen Temperatursensor an eine Verarbeitungseinheit;
- Bestimmen (130) von n-1 Änderungsraten der Temperatur durch die Verarbeitungseinheit für einen oder mehrere Orte des mindestens eines Ortes in Bezug auf die n Temperaturdaten für die einen oder mehreren Orte zu den n Zeitpunkten;
- Bestimmen von n-1 Korrelationsdatenpunkten durch die Verarbeitungseinheit, wobei jeder Korrelationsdatenpunkt eine Korrelation zwischen jeder Änderungsrate der Temperatur der n-1 Änderungsraten der Temperatur mit einer zugeordneten Temperatur ist, wobei für eine bestimmte Änderungsrate der Temperatur die zugeordnete Temperatur eine erste Temperatur der zwei Temperaturen ist, die zur Bestimmung der bestimmten Änderungsrate der Temperatur verwendet werden, oder eine zweite Temperatur der zwei Temperaturen, oder ein Mittelwert der ersten und zweiten Temperatur der zwei Temperaturen, die zur Bestimmung der bestimmten Änderungsrate der Temperatur verwendet werden;
- Bestimmen (140) eines Zustands der Schaltanlage durch die Verarbeitungseinheit, wobei das Bestimmen des Zustands der Schaltanlage die Verwendung der n-1 Änderungsraten der Temperatur für die einen oder mehreren Orte, mindestens n-1 der n Temperaturdaten für die einen oder mehreren Orte und eine Form der n-1 Korrelationsdatenpunkte umfasst; und
- Ausgeben (150) des bestimmten Zustands der Schaltanlage durch eine Ausgabeeinheit, wenn der bestimmte Zustand der Schaltanlage als nicht normal oder nicht funktionsfähig ermittelt wird.

12. Schaltanlage (50), umfassend ein System (10) nach einem der Ansprüche 1-10.

13. Computerprogrammprodukt zur Steuerung eines Systems nach einem der Ansprüche 1-10, das beim Ausführen durch einen Prozessor dazu eingerichtet ist, das Verfahren nach Anspruch 11 auszuführen.

## Revendications

1. Système (10) de surveillance d'un appareillage de commutation, le système comprenant :
- au moins un capteur de température (20) ;
- une unité de traitement (30) ; et
- une unité de sortie (40) ;
dans lequel l'au moins un capteur de température est configuré pour acquérir des données de température pour chaque emplacement d'au moins un emplacement d'un appareillage de commutation (50) à n points temporels ;
dans lequel l'au moins un capteur de température est configuré pour fournir les données de température à l'unité de traitement ;
dans lequel l'unité de traitement est configurée pour déterminer n-1 taux de changement de température pour un ou plusieurs emplacements de l'au moins un emplacement par rapport aux n données de température pour l'un ou les plusieurs emplacements aux n points temporels ;
dans lequel l'unité de traitement est configurée pour déterminer n-1 points de données de corrélation, dans lequel chaque point de données de corrélation est une corrélation entre chaque taux de changement de température des n-1 taux de changement de température et une température associée, dans lequel, pour un taux particulier de changement de température, la température associée est une première température de deux températures utilisée pour déterminer le taux particulier de changement de température ou est une seconde température des deux températures utilisée pour déterminer le taux particulier de changement de température ou est une moyenne de la première température et de la seconde température des deux températures utilisées pour déterminer le taux particulier de changement de température ;
dans lequel l'unité de traitement est configurée pour déterminer un état de l'appareillage de commutation, dans lequel la détermination de l'état de l'appareillage de commutation comprend l'utilisation des n-1 taux de changement de température pour l'un ou les plusieurs emplacements, d'au moins n-1 des n données de température pour l'un ou les plusieurs emplacements, et d'une forme des n-1 points de données de corrélation ; et
dans lequel l'unité de sortie est configurée pour sortir l'état déterminé de l'appareillage de commutation lorsque l'état déterminé de l'appareillage de commutation est déterminé comme n'étant pas normal ou comme n'étant pas bon.

2. Système selon la revendication 1, dans lequel la détermination de l'état de l'appareillage de commutation comprend l'utilisation des n données de température pour l'un ou les plusieurs emplacements.

3. Système selon quelconques des revendications 1 et 2, dans lequel l'au moins un capteur de température est configuré pour acquérir des données de température pour l'au moins un emplacement de l'appareillage de commutation (50) à m points temporels, dans lequel m est supérieur à n, et dans lequel les n points temporels sont des points temporels consécutifs des m points temporels.

4. Système selon quelconques des revendications 1 à 3, dans lequel chacun des n-1 taux de changement de température est déterminé pour des données de température consécutives des n données de température pour l'un ou les plusieurs emplacements.

5. Système selon quelconques des revendications 1 à 4, dans lequel l'au moins un capteur de température comprend une ou plusieurs caméras infrarouges, et dans lequel les données de température pour l'au moins un emplacement aux n points temporels sont déterminées à partir d'une ou de plusieurs images infrarouges acquises à chacun des n points temporels.

6. Système selon la revendication 1 à 4, dans lequel l'au moins un capteur de température comprend un ou plusieurs capteurs de point situés à l'au moins un emplacement, et dans lequel les données de température pour l'au moins un emplacement aux n points temporels sont acquises par l'un ou les plusieurs capteurs de point à chacun des n points temporels.

7. Système selon quelconques des revendications 1 à 6, dans lequel l'un ou les plusieurs emplacements sont déterminés comme étant un ou plusieurs emplacements avec une ou plusieurs températures maximums.

8. Système selon quelconques des revendications 1 à 7, dans lequel l'appareillage de commutation comprend une pluralité de compartiments, dans lequel l'un ou les plusieurs emplacements comprennent une pluralité d'emplacements, et dans lequel chaque emplacement de pluralité de emplacements est situé dans un différent compartiment de la pluralité de compartiments.

9. Système selon quelconques des revendications 1 à 8, dans lequel l'unité de traitement est configurée pour mettre en œuvre un algorithme d'apprentissage machine, et dans lequel la détermination de l'état de l'appareillage de commutation comprend l'utilisation de l'algorithme d'apprentissage machine, et dans lequel l'algorithme d'apprentissage machine a été entraîné sur la base de taux de changement de données de température et de données de température associées.

10. Système selon la revendication 9, dans lequel les taux de changement de température et données de température associées utilisés pour entraîner l'algorithme d'apprentissage machine comprennent des données pour l'au moins un emplacement de l'appareillage de commutation ou un appareillage de commutation équivalent.

11. Procédé (100) de surveillance d'un appareillage de commutation, le procédé comprenant :
- l'acquisition (110), par au moins un capteur de température, de données de température pour chaque emplacement d'au moins un emplacement d'un appareillage de commutation à n points temporels ;
- la fourniture (120), par l'au moins un capteur de température, des données de température à une unité de traitement ;
- la détermination (130), par l'unité de traitement, de n-1 taux de changement de température pour un ou plusieurs emplacements de l'au moins un emplacement par rapport aux n données de température pour l'un ou les plusieurs emplacements aux n points temporels ;
- la détermination, par l'unité de traitement, de n-1 points de données de corrélation, dans lequel chaque point de données de corrélation est une corrélation entre chaque taux de changement de température des n-1 taux de changement de température et une température associée, dans lequel, pour un taux particulier de changement de température, la température associée est une première température de deux températures utilisées pour déterminer le taux particulier de changement de température ou est une seconde température des deux températures utilisées pour déterminer le taux particulier de changement de température ou est une moyenne de la première température et de la seconde température des deux températures utilisées pour déterminer le taux particulier de changement de température ;
- la détermination (140), par l'unité de traitement, d'un état de l'appareillage de commutation, dans lequel la détermination de l'état de l'appareillage de commutation comprend l'utilisation des n-1 taux de changement de température pour l'un ou les plusieurs emplacements, d'au moins n-1 des n données de température pour l'un ou les plusieurs emplacements, et d'une forme des n-1 points de données de corrélation ; et
- la sortie (150), par une unité de sortie, de l'état déterminé de l'appareillage de commutation lorsque l'état déterminé de l'appareillage de commutation est déterminé comme n'étant pas normal ou comme n'étant pas bon.

12. Appareillage de commutation (50), comprenant un système (10) selon quelconques des revendications 1 à 10.

13. Élément de programme d'ordinateur pour commander un système selon quelconques des revendications 1 à 10 qui, lorsqu'il est exécuté par un processeur, est configuré pour effectuer le procédé de la revendication 11.
